(19) Europäisches Patentamt
European Patent Office
Office européen des brevets

(11) **EP 4 245 871 A1**

(12) **DEMANDE DE BREVET EUROPEEN**

(43) Date de publication:
**20.09.2023 Bulletin 2023/38**

(21) Numéro de dépôt: **22163092.4**

(22) Date de dépôt: **18.03.2022**

(51) Classification Internationale des Brevets (IPC):
***C22C 5/02*** (2006.01)   ***A44C 27/00*** (2006.01)
***C23C 14/00*** (2006.01)

(52) Classification Coopérative des Brevets (CPC):
**C22C 5/02; A44C 27/003; C23C 14/00**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(71) Demandeur: **Nivarox-FAR S.A.**
**2400 Le Locle (CH)**

(72) Inventeurs:
• **VANNOD, Jonas**
**2503 Bienne (CH)**
• **FAYS, Vincent**
**2072 Saint-Blaise (CH)**
• **CHARBON, Christian**
**2054 Chézard-St-Martin (CH)**

(74) Mandataire: **ICB SA**
**Faubourg de l'Hôpital, 3**
**2001 Neuchâtel (CH)**

(54) **ALLIAGE D'OR**

(57)     L'invention concerne un alliage d'or comprenant en poids entre 73% et 77% d'or, entre 20% et 24.5% d'argent, du palladium et/ou du platine avec un pourcentage total pour ces deux éléments compris entre 0.5% et 5%.

Cet alliage grâce à l'ajout de palladium et/ou de platine présente une résistance au ternissement améliorée tout en ayant une teinte verte.

## Fig. 2

EP 4 245 871 A1

**Description**

Domaine technique de l'invention

La présente invention se rapporte à un alliage d'or et plus spécifiquement à un alliage d'or vert. Elle se rapporte également à un article dont une pièce d'horlogerie, réalisé en masse avec cet alliage ou comprenant en surface un revêtement de cet alliage.

Arrière-plan technologique

Les alliages d'or 18K de couleur sont très demandés pour la production de pièces d'horlogerie. Les compositions d'alliages d'or vert disponibles dans la littérature contiennent toutes de l'argent et éventuellement du zinc, du cuivre, du cadmium ou une combinaison de plusieurs de ces éléments.

L'ajout d'argent en grande proportion est le paramètre principal permettant de garantir une teinte la plus prononcée possible. Ainsi, la composition la plus prometteuse pour les alliages d'or vert 18K est celle de l'alliage Au750Ag250, avec en poids 75% d'Au et 25% d'Ag, aussi connu sous le nom d'électrum. Cependant, l'argent ternit très rapidement et ceci constitue un des handicaps principaux de cette famille d'alliage.

Résumé de l'invention

L'invention a pour objet de pallier au désavantage précité en proposant un nouvel alliage d'or vert avec une résistance au ternissement améliorée.

A cet effet, la composition chimique de l'alliage d'or a été adaptée. L'alliage d'or ainsi développé est un alliage 18 carats comprenant de l'argent, du palladium et/ou du platine.

Plus précisément, l'alliage d'or comprend en poids entre 73% et 77% d'or, entre 20% et 24.5% d'argent, du palladium et/ou du platine avec un pourcentage total pour ces deux éléments compris entre 0.5% et 5%.

Avantageusement, l'invention concerne un alliage d'or ternaire constitué d'or, d'argent et de palladium. Optionnellement, il peut comporter en faibles quantités, à savoir maximum 0.05% en poids pour l'ensemble des éléments, un ou plusieurs éléments choisis parmi l'iridium, le rhénium et le ruthénium.

L'ajout de palladium permet d'obtenir une teinte proche de celle de l'électrum tout en réduisant drastiquement le ternissement dans le temps de l'alliage. Un effet similaire est observé avec l'ajout de platine.

D'autres caractéristiques et avantages de l'invention apparaîtront à la lecture de la description détaillée qui va suivre, en référence aux dessins annexés.

Brève description des figures

La figure 1 représente dans l'espace colorimétrique CIELAB les paramètres a* et b* pour les alliages selon l'invention et celui selon l'art antérieur.

La figure 2 représente le changement de couleur ($\Delta$E) en fonction du temps pour un alliage selon l'invention et deux alliages de référence.

La figure 3 représente un cadran réalisé avec l'alliage d'or selon l'invention.

Description détaillée de l'invention

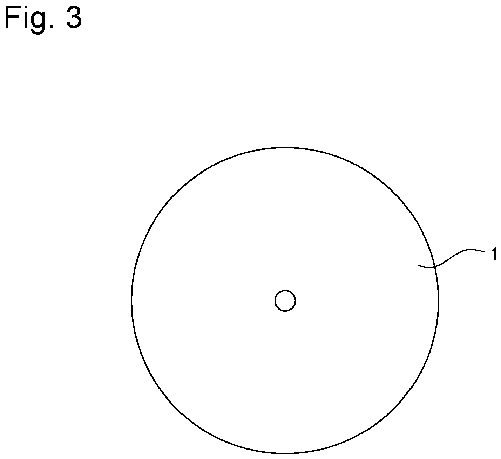

La présente invention se rapporte à un alliage d'or 18 carats plus particulièrement destiné à une application dans le domaine de l'horlogerie, de la bijouterie ou de la joaillerie. Elle se rapporte ainsi également aux pièces d'horlogerie, de bijouterie ou de joaillerie réalisées dans cet alliage. On entend par pièces d'horlogerie aussi bien des composants d'habillage tels qu'une carrure, un fond, une lunette, un poussoir, un maillon de bracelet, un rehaut, un cadran, une aiguille, un index de cadran, une masse oscillante, etc., que des composants du mouvement tels qu'une platine, un pont ou un balancier. Selon l'invention, lesdites pièces d'horlogerie, de bijouterie ou de joaillerie sont réalisées en masse avec ledit alliage d'or ou comporte en surface un revêtement réalisé avec ledit alliage d'or. Lorsqu'il s'agit d'un composant d'habillage extérieur, le composant est de préférence revêtu avec ledit alliage d'or. Lorsqu'il s'agit d'un composant d'habillage intérieur, ledit composant est réalisé en masse ou revêtu avec ledit alliage d'or. Dans le cas d'un revêtement, à titre d'exemple, le substrat peut être en laiton ou en or, par exemple, 18 carats. Un exemple plus spécifique est un cadran 1 réalisé en masse avec ledit alliage ou revêtu avec ledit alliage, tel que représenté à la figure 3.

De manière plus générale, ledit alliage d'or peut être utilisé en masse ou en surface pour tout article. Le champ d'application de l'alliage d'or selon l'invention couvre également les cibles utilisées dans les procédés de revêtement tels que le dépôt physique en phase vapeur (PVD).

L'alliage d'or selon l'invention comprend en poids entre 73% et 77% d'or, entre 20% et 24.5% d'argent, du palladium et/ou du platine avec un pourcentage total pour ces deux éléments compris entre 0.5% et 5%.

Avantageusement, l'alliage d'or comprend en poids entre 73% et 77% d'or, entre 21% et 24.3% d'argent, du palladium et/ou du platine avec un pourcentage total pour ces deux éléments compris entre 0.7% et 4%.

De préférence, l'alliage d'or comprend en poids entre 73.5% et 76.5% d'or, entre 22.5% et 24.3% d'argent, du palladium et/ou du platine avec un pourcentage total pour ces deux éléments compris entre 0.7% et 2.5%.

Plus préférentiellement, l'alliage d'or comprend en poids entre 74% et 76% d'or, entre 23.5% et 24.3% d'argent, du palladium et/ou du platine avec un pourcentage total pour ces deux éléments compris entre 0.7% et 1.5%.

En outre, l'alliage d'or comprend optionnellement en poids entre 0 et 0,05% (bornes comprises) d'un ou plusieurs éléments choisis parmi l'iridium, le rhénium et le ruthénium, la gamme 0-0.05% couvrant le pourcentage total du ou de ces éléments. De manière avantageuse, l'alliage d'or comprend en poids 0.0025% d'iridium.

Préférentiellement, l'alliage d'or est constitué dans les proportions précitées de l'or, de l'argent, du palladium et/ou du platine et optionnellement d'un ou plusieurs des éléments choisis parmi l'iridium, le rhénium et le ruthénium.

Pour préparer l'alliage d'or, les différents éléments de la composition sont mis en fusion avant d'être coulés. Le lingot de coulée est ensuite mis en forme par laminage à la coche, laminage à plat, étirage ou tréfilage. Il est déformé avec un taux d'écrouissage compris entre 10% et 80% réparti en plusieurs passes avec, éventuellement, des recuits intermédiaires réalisés dans une gamme de températures comprises entre 550°C et 750°C, pendant un temps compris entre 5 minutes et 30 minutes. Dans les exemples ci-après, les échantillons sont recuits à une température de 650°C pendant 30 minutes. Après refroidissement, les ébauches sont mises à dimension, par exemple, par usinage. Il est également envisageable que les ébauches soient à l'état écroui pour faciliter l'usinage, un recuit pouvant éventuellement être réalisé après usinage.

Dans le cadre d'un revêtement avec ledit alliage d'or sur un substrat, le procédé de dépôt peut être un procédé de dépôt physique en phase vapeur (PVD pour physical vapor déposition en anglais) ou encore un dépôt chimique en phase vapeur (CVD pour chemical vapor déposition en anglais).

Les alliages obtenus après déformation et recuits ou sous forme de revêtement présentent dans l'espace colorimétrique CIELAB (conforme aux normes CIE n°15, ISO 7724/1, DIN 5033 Teil 7, ASTM E-1164) une valeur $a^*$ comprise entre -7 et 1, de préférence entre -5 et 0, et une valeur $b^*$ comprise entre 20 et 32, de préférence entre 22 et 30; les valeurs $a^*$ et $b^*$ définissant ensemble la teinte de l'alliage. Ils présentent en outre une valeur L comprise entre 80 et 95, les valeurs $L^*a^*b^*$ définissant ensemble la couleur de l'alliage. Selon la présente invention, l'accent est mis plus spécifiquement sur les valeurs $a^*$ et $b^*$ qui définissent la teinte de l'alliage. Selon l'invention, l'alliage d'or a une teinte verte.

Ces alliages d'or présentent une dureté comprise entre 35 et 60 HV1, de préférence entre 40 et 55 HV1 à l'état recuit. Ces alliages d'or ont une densité comprise entre 15 et 17.

Le Tableau 1 donne la composition en poids de l'alliage d'or 18 carats de référence électrum et de quatre alliages d'or 18 carats selon l'invention. Les valeurs colorimétriques et la dureté (HV1) mesurées sont aussi présentées dans le Tableau 1 pour certaines compositions sur des échantillons déformés et recuits à 650°C pendant 30 minutes. Les valeurs colorimétriques $L^*a^*b^*$ ont été mesurées avec un spectrophotomètre KONICA MINOLTA CM-2600d avec un illuminant D65 et un angle d'observation de 10°.

| | Compositions (% en poids) | | | | Densité | Dureté | Colorimétrie | | |
|---|---|---|---|---|---|---|---|---|---|
| | Or | Ag | Pd | Pt | | HV1 | L | a | b |
| Référence | 75,06 | 24,94 | 0 | 0 | 16 | 46 | 92.5 | -3,68 | 28,04 |
| Invention | 75,06 | 23,94 | 1 | 0 | 16 | 47 | 90,52 | -2,25 | 26,28 |
| | 75,06 | 22,94 | 2 | 0 | 16 | 49 | 89,27 | -1,01 | 24,36 |
| | 75,06 | 21,94 | 3 | 0 | 16 | / | / | / | / |
| | 75,06 | 23,94 | 0 | 1 | 16 | / | / | / | / |

## Tableau 1

On observe peu de variations de la dureté avec des valeurs comprises entre 45 et 50 HV1 à l'état recuit.

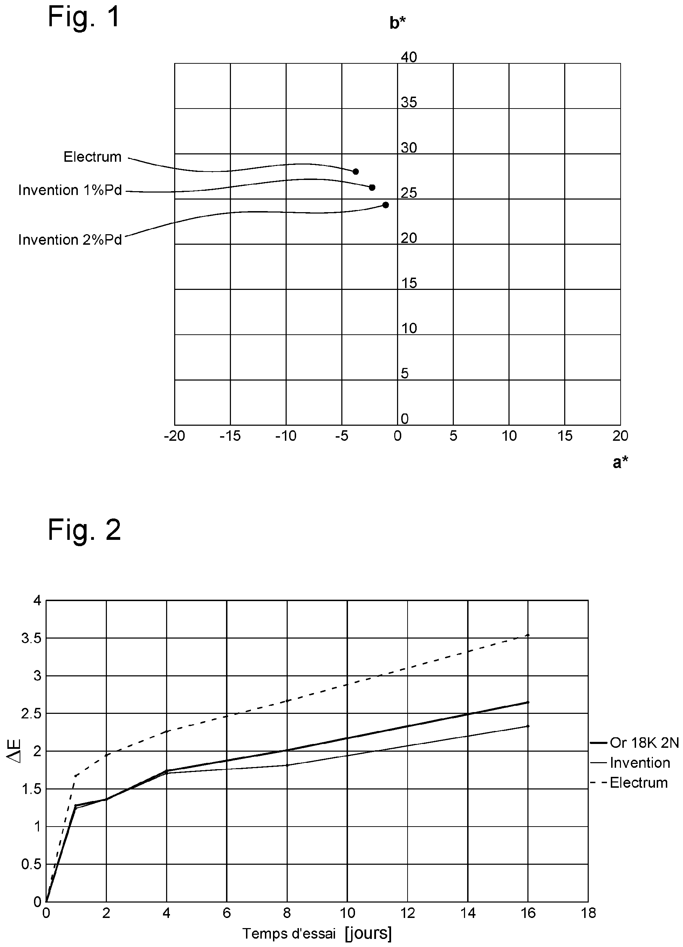

On observe à la figure 1 que l'ajout de palladium n'altère que faiblement la teinte avec des valeurs $a^*$ et $b^*$ qui sont proches de celles de l'électrum.

La figure 2 représente le Delta E qui est la variation de couleur au cours du temps sur une période de 16 jours pour deux échantillons de référence qui sont l'électrum et un or 18K 2N (75% d'or, 16% d'argent et 9% de cuivre en poids) et un alliage d'or selon l'invention comprenant de l'argent et du palladium avec un pourcentage en poids de palladium de 2%. Le Delta E est calculé sur base des valeurs L*a*b* comme suit avec $L_1^*$, $a_1^*$ et $b_1^*$ se référant aux valeurs au temps 0.

$$\Delta E^* = [(L_2^* - L_1^*)^2 + (a_2^* - a_1^*)^2 + (b_2^* - b_1^*)^2]^{1/2}$$

On remarque que l'ajout de palladium réduit le ternissement de manière significative, ce qui le rend comparable, voire moins sensible que l'or 2N au ternissement.

## Revendications

1. Alliage d'or comprenant en poids entre 73% et 77% d'or, entre 20% et 24.5% d'argent, du palladium et/ou du platine avec un pourcentage total pour ces deux éléments compris entre 0.5% et 5%.

2. Alliage d'or selon la revendication précédente, **caractérisé en ce qu'**il comprend en poids entre 73% et 77% d'or, entre 21% et 24.3% d'argent, du palladium et/ou du platine avec un pourcentage total pour ces deux éléments compris entre 0.7% et 4%.

3. Alliage d'or selon l'une des revendications précédentes, **caractérisé en ce qu'**il comprend en poids entre 73.5% et 76.5% d'or, entre 22.5% et 24.3% d'argent, du palladium et/ou du platine avec un pourcentage total pour ces deux éléments compris entre 0.7% et 2.5%.

4. Alliage d'or selon l'une des revendications précédentes, **caractérisé en ce qu'**il comprend en poids entre 74% et 76% d'or, entre 23.5% et 24.3% d'argent, du palladium et/ou du platine avec un pourcentage total pour ces deux éléments compris entre 0.7% et 1.5%.

5. Alliage d'or selon l'une des revendications précédentes, **caractérisé en ce qu'**il est constitué d'or, d'argent, de palladium et/ou de platine, et optionnellement d'un ou plusieurs éléments choisis parmi l'iridium, le rhénium et le ruthénium avec un pourcentage total en poids pour ces éléments compris entre 0 et 0.05%.

6. Alliage d'or selon l'une des revendications précédentes, **caractérisé en ce qu'**il comporte du palladium et pas de platine.

7. Alliage d'or selon l'une des revendications précédentes, **caractérisé en ce qu'**il a une densité comprise entre 15 et 17.

8. Alliage d'or selon l'une des revendications précédentes, **caractérisé en ce qu'**il a dans l'espace colorimétrique CIELAB une valeur a* comprise entre -7 et 1, de préférence entre -5 et 0, et une valeur b* comprise entre 20 et 32, de préférence entre 22 et 30.

9. Alliage d'or selon l'une des revendications précédentes, **caractérisé en ce qu'**il a une dureté HV1 comprise entre 35 et 60 HV1, de préférence entre 40 et 55 HV1, à l'état recuit.

10. Article réalisé avec l'alliage d'or selon l'une des revendications précédentes ou comprenant un revêtement réalisé avec ledit alliage d'or selon l'une des revendications précédentes.

11. Article selon la revendication précédente, **caractérisé en ce qu'**il s'agit d'une pièce d'horlogerie, de bijouterie ou de joaillerie.

12. Cible pour le dépôt d'un revêtement sur un substrat, ladite cible étant réalisée avec l'alliage d'or selon l'une des revendications 1 à 9.

## Fig. 1

## Fig. 2

Fig. 3

1

Europäisches
Patentamt

European
Patent Office

Office européen
des brevets

**RAPPORT DE RECHERCHE EUROPEENNE**

Numéro de la demande

**EP 22 16 3092**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | JP 2000 150562 A (MITSUBISHI MATERIALS CORP) 30 mai 2000 (2000-05-30) * alinéas [0014] - [0022]; exemples 2,15; tableau 1 * | 1-5,7-12 | INV. C22C5/02 A44C27/00 C23C14/00 |
| X | JP H11 45899 A (SUMITOMO METAL MINING CO) 16 février 1999 (1999-02-16) * alinéas [0012] - [0021]; exemple 2; tableau 1 * | 1,5-10 | |
| X | JP H11 45901 A (SUMITOMO METAL MINING CO) 16 février 1999 (1999-02-16) * alinéas [0013] - [0025]; exemple 13; tableau 1 * | 1,5,7-10 | |
| A | US 2012/312428 A1 (MIKAMI MICHITAKA [JP]) 13 décembre 2012 (2012-12-13) * alinéas [0041] - [0050]; tableau 2 * | 1-12 | |
| A | JP 2018 066038 A (NARUSE SHIGEYASU; MAONE CO LTD) 26 avril 2018 (2018-04-26) * alinéas [0009] - [0027] * | 1-12 | DOMAINES TECHNIQUES RECHERCHES (IPC)

C22C
A44C
C23C |

Le présent rapport a été établi pour toutes les revendications

| Lieu de la recherche | Date d'achèvement de la recherche | Examinateur |
|---|---|---|
| La Haye | 31 août 2022 | Barenbrug-van Druten |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

**EP 22 16 3092**

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

**31-08-2022**

| Document brevet cité au rapport de recherche | | Date de publication | Membre(s) de la famille de brevet(s) | | Date de publication |
|---|---|---|---|---|---|
| JP 2000150562 | A | 30-05-2000 | JP | 3329286 B2 | 30-09-2002 |
| | | | JP | 2000150562 A | 30-05-2000 |
| JP H1145899 | A | 16-02-1999 | JP | 3672063 B2 | 13-07-2005 |
| | | | JP | H1145899 A | 16-02-1999 |
| JP H1145901 | A | 16-02-1999 | JP | 3633222 B2 | 30-03-2005 |
| | | | JP | H1145901 A | 16-02-1999 |
| US 2012312428 | A1 | 13-12-2012 | CN | 103155129 A | 12-06-2013 |
| | | | DE | 112011100491 T5 | 13-06-2013 |
| | | | KR | 20140033299 A | 18-03-2014 |
| | | | SG | 186692 A1 | 28-03-2013 |
| | | | US | 2012312428 A1 | 13-12-2012 |
| | | | WO | 2012169067 A1 | 13-12-2012 |
| JP 2018066038 | A | 26-04-2018 | JP | 6863657 B2 | 21-04-2021 |
| | | | JP | 2018066038 A | 26-04-2018 |

EPO FORM P0460